# EUROPEAN PATENT APPLICATION

(11) **EP 0 615 273 A1**
(43) Date of publication of application: **14.09.1994**
(21) Application number: 94301156.9
(22) Date of filing: 17.02.1994
(51) Int. Cl.: H01J 37/32

(54) **Method and apparatus for detection of sputtering target erosion**

(30) Priority: 12.03.1993 US 30756
(71) Applicant: APPLIED MATERIALS, INC., Santa Clara California 95054-3299 (US)
(72) Inventor: Grunes, Howard, Santa Cruz, CA 95062 (US)
(74) Representative: Bayliss, Geoffrey Cyril

(57) **Abstract**

The disclosure relates to glow discharge sputtering systems used for sputter coating or deposition. In particular, the method and apparatus (100) of the present invention enables the detection of the exhaustion of (effective penetration of) the sputtering target (110) which provides the sputter coating or deposition material from its surface (114). The sputtering target is constructed to include at least one identifier (120) within said sputtering target, which identifier is exposed when the sputtering target is sufficiently eroded. The identifier is located at a preselected sputtering target thickness or erosion depth. The sputtering target is used in combination with a means for detecting the exposure of the identifier. Preferably, the identifier is a passageway (120) which contains a gas which is emitted upon exposure of the passageway. Detection of exposure of the passageway is accomplished by a pressure sensitive switch (124) which detects the release of the gas contained in the passageway. Exposure of the passageway serves as an indication that the preselected target erosion depth has been reached at least in the area of the passageway. The means for detecting exposure of the passageway can be used in combination with a control device which shuts down the sputtering process when the preselected sputtering target thickness is reached, so the sputtering target can be replaced.

## Description

The present invention relates generally to electrode-type glow discharge sputtering systems used for sputter coating, and more particularly to the kind of devices used in the semiconductor industry for application of thin films of materials to semiconductor structures, The method and apparatus of the present invention enable the detection of the exhaustion of (penetration through) the sputtering target which provides the source of the film material. In particular, the method and apparatus enable the detection of the time at which erosion of the sputtering target surface reduces at least portions of the target to a preselected thickness.

In the manufacture of many electronic or electrical components, such as integrated circuits, there is a need to deposit thin films on substrates. Materials such as, for example, aluminum, titanium, tungsten, tantalum, tantalum nitride, cobalt, and silica may be deposited on ceramic, glass, or silicon-derived substrates by a sputtering process and subsequently etched or otherwise fabricated into the circuits and/or components.

In the typical sputtering process, a low pressure atmosphere of an ionizable gas such as argon or helium is produced in a vacuum chamber. Two electrodes, a cathode and an anode, are generally disposed in this enclosure. The cathode is typically made of the material to be deposited or sputtered, and the anode is generally formed by the enclosure of the apparatus. At times, an auxiliary anode may be used or the article to be coated may serve as the anode. Typically a high voltage is applied between these two electrodes, and the substrate to be coated is disposed opposite the cathode. The cathode emits electrons which ionize the gas, for example argon, by collision. The resulting argon ions are accelerated by the high-voltage field, and may be further directed in magnetron sputtering systems using a shaped magnetic field. The ions bombard the cathode with the result that microparticles of the cathode are bombarded off and caused to move within the enclosure, leaving a deposit of cathode material on the substrate to which it is to be applied.

The cathode used in the manner described above is commonly called a sputtering target, and this sputtering target is gradually consumed via "erosion" of the target by the ion bombardment. The target bombardment generates a substantial amount of heat which must be removed to control the temperature of the target, the substrate being coated, and the components constituting the sputtering chamber. Heat removal can be accomplished by contacting a target heat-transfer surface (other than the sputtering surface) with a solid surface which is cooled by passing a cooling liquid through conduits within the solid surface. A more efficient method of cooling the sputtering target is to contact the target heat transfer surface directly with the cooling liquid. The cooling liquid can be any liquid which has good heat transfer characteristics and is not highly corrosive to the sputtering target. Water is commonly used as the cooling agent, due to its excellent heat transfer characteristics and known physical and chemical behavior.

When the cooling liquid is contacted directly with the sputtering target, there is the risk that the target may be eroded through and the cooling liquid leak into the vacuum chamber in which the sputtering operation is carried out. Should cooling liquid penetrate an eroded sputtering target and leak into this sputtering chamber, the workpiece (substrate) may be contaminated, and other compenents in the sputtering system damaged as well. A method of avoiding penetration of the sputtering target by the cooling liquid is described in U.S. Patent No. 5,039,913 to Wegman et al., issued August 13, 1991. Wegman et al. disclose a sputtering target having direct cooling liquid contact with the rear (non-sputtering) surface of the target. However, the target surface is actively cooled only in exclusive regions spaced from erosion-prone target regions; that is, the cooling takes place in regions along the target profile outside the regions of greatest erosion rate. This method provides less effective heat transfer and requires knowledge of the exact profile at which maximum erosion of the target will occur.

U.S. Patent No. 4,500,409 to Boys et al., issued February 19, 1985, describes a magnetron sputter coating source for both magnetic and non-magnetic target materials. The sputtering target is cooled using direct contact between cooling water and the bottom side of the target. Unlike Wegman et al., the cooling water is permitted to flow in the region of maximum target erosion; however, a Hall probe is used adjacent to the water-cooled side of the sputter target at this location, to provide an indication of the amount of target erosion which has occurred. The Hall probe is useful only with magnetic targets, since this probe operates by sensing the magnetic field in the location of the target at which it is placed. The magnetic field sensed by the Hall probe changes rapidly with target erosion. The data provided by the Hall probe "provides valuable independent information regarding the approach to the end of the useful life (of the target), thereby helping to avoid a catastrophic leak from the water chamber through the sputter target." The problem with this approach is that it works only for magnetic targets. In addition, a time-dependent magnetic field profile must be developed for each kind of target material and for each target shape.

As can be understood from the descriptions provided above, it would be very useful to have a means for detecting when the sputtering target reaches a particular thickness at the maximum erosion location. The sputtering process could be stopped at such time, to avoid penetration of cooling liquid through the sputtering target.

In accordance with the present invention, a method and apparatus is provided which enables the detection of the time at which a sputtering target becomes eroded to the extent that a preselected sputtering target thickness remains in the areas of maximum sputtering target erosion. The sputtering target is constructed to have an identifier present at a preselected target depth. This sputtering target is used in combination with a means for detecting exposure of the identifier, which occurs when the target has been eroded to the preselected target depth. The identifier is different in character from overlaying target material which is eroded to expose the identifier. The identifier can be detected using optical, pressure variation, or material composition measuring means, for example.

In a preferred embodiment of the invention, the sputtering target can be constructed to have at least one passageway which is present at the preselected target depth or thickness. This sputtering target is used in combination with a means for detecting exposure of the passageway, which occurs when the target has been eroded to the preselected depth.

In a highly preferred embodiment, the sputtering target is constructed to contain at least one passageway which acts as a source for emission of a gas. This sputtering target can be used in combination with a means for detecting release of gas from the passageway, which occurs upon sufficient erosion of the target so that the interior of the passageway is exposed. Detection of the gas release can be accomplished using a means for detecting pressure change or by using a gas composition detection means. Detection of the release of gas from the passageway can be used as input to a control device which takes some action within the sputtering system, such as shutting down the sputtering apparatus so the sputtering target can be replaced. This embodiment of the invention provides the advantage of inexpensive target construction.

When release of a gas is used as indication of exposure of the passageway, typically the gas to be released is entrapped within the sputtering target or is infused into the sputtering target at the desired location. When the patterns of maximum sputtering target erosion are known for a given sputtering apparatus and target composition, it is possible to construct a conduit within the sputtering target area at which this maximum erosion occurs. When the sputtering target has eroded to the extent that the conduit interior becomes exposed, gas is released from the conduit and travels into the vacuum chamber in which the sputtering process is being carried out. Presence of the gas within the sputtering apparatus vacuum chamber can be detected either by an increase in pressure within the vacuum chamber or by detection of a change in gas composition within the vacuum chamber. In one alternative, the gas source can be pressurized in itself and includes a pressure sensitive switch which indicates the release of gas from the pressurized source of gas into the sputtering apparatus vacuum chamber.

The identifier which is present at the preselected target depth can be present over the entire sputtering target surface area at the particular target thickness of interest, when the areas of maximum target erosion are not known. When the identifier is a passageway containing a gas and extends over the entire target heat transfer area dimensions, such gas can act as an insulator, reducing the desired heat transfer within the sputtering target; in such case it may be necessary to design around this heat transfer problem. Insulation by a gas source can be reduced by having the gas present in a porous material which is capable of conducting heat well even with the gas present, or by having the gas present in a number of conduits, wherein the total conduit volume is such a small proportion of the target volume as to have a minimal effect on heat transfer.

The following is a description of some specific embodiments of the invention reference being made to the accompanying drawings, in which:

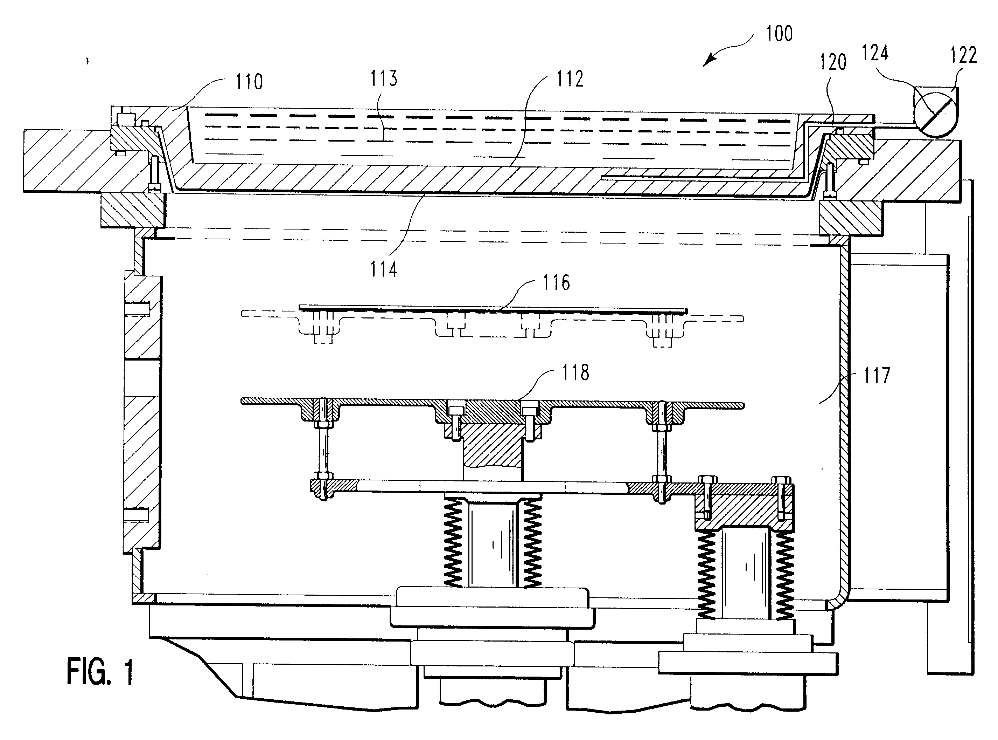

FIGURE 1 is a cross-sectional side view schematic of a sputtering apparatus 100 of the kind which can be used to practice the present invention. This schematic is not intended to show all of the elements contained within a sputtering apparatus, nor all of the elements comprising a sputtering system.

The sputtering apparatus 100 includes a sputtering target 110 with a gas-containing conduit 120 near sputtering target heat transfer surface 112. Heat transfer surface 112 typically directly contacts cooling liquid 113 used to cool sputtering target 110. Sputtering target 110 also has initial sputtering surface 114 which is eroded away during the sputtering operation to provide the material for the sputtering deposition. As a result of the erosion of the sputtering surface, the interior of gas-containing conduit 120 is eventually exposed, and the gas contained therein is released or emitted. Means for detection of the release of gas from conduit 120 can be, for example, a gas composition analysis device (not shown) located inside sputtering apparatus 100 vacuum chamber 117, or an device capable of sensing variation in pressure. The pressure variation sensing device can be located inside vacuum chamber 117 or can be in communication with a pressurized gas source 122, such as pressure switch 124 shown in FIG. 1.

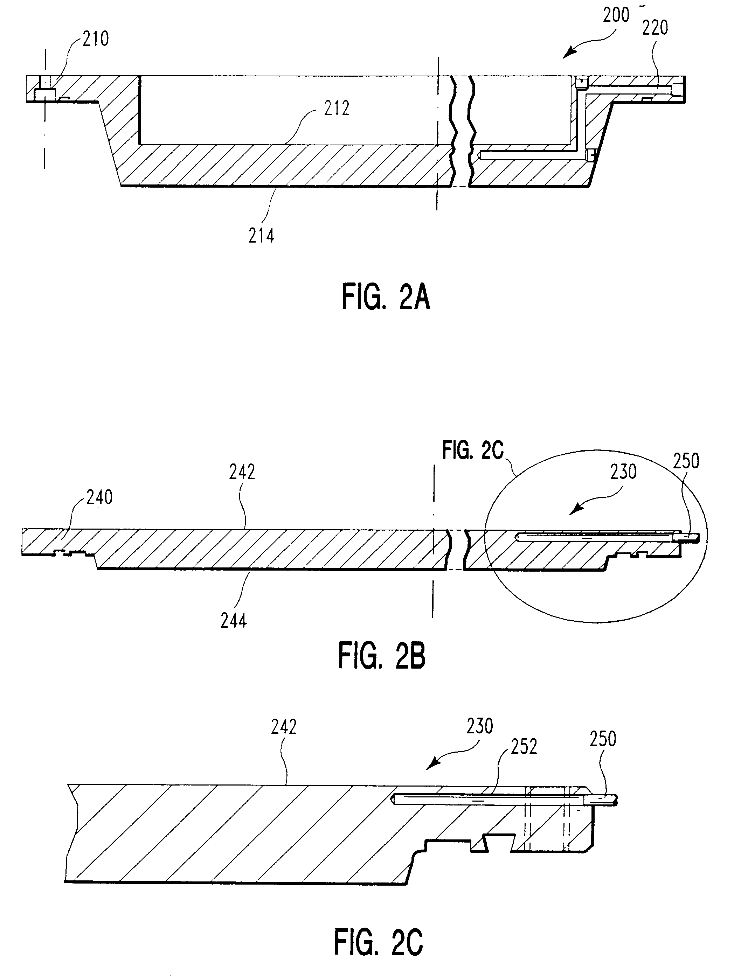

FIGURES 2A - 2C are cross-sectional side view schematics of typical sputtering targets of the kind which can be used to practice the present invention. The sputtering target shown in FIG. 2A is representative of a concave, "dish-shaped" sputtering target, whereas the sputtering target shown in FIG. 2B represents a "flat-surfaced" sputtering target. Typically targets of the kind shown in FIGS. 2A and 2B are circular from a top view, however this is not necessary for practice of the invention. FIG. 2C shows a detailed enlargement of a gas-containing conduit 250 used near heat transfer surface 242 of sputtering target 230 which is shown in FIG. 2B.

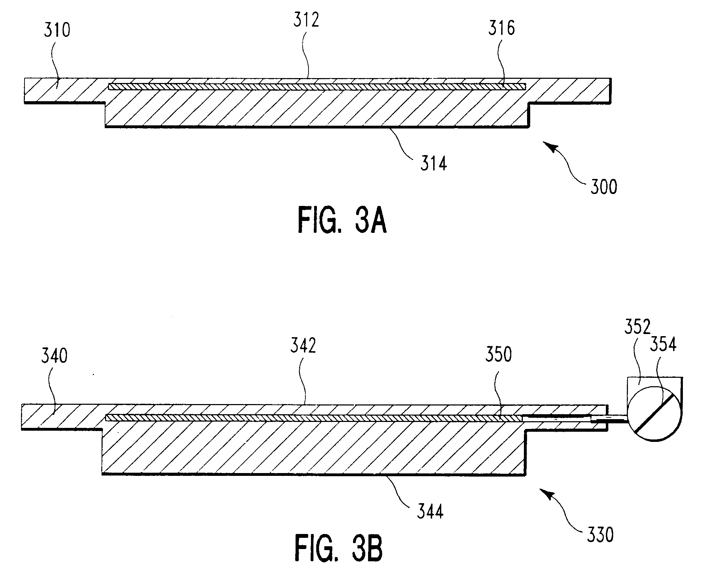

FIGURES 3A and 3B are cross-sectional side view schematics of a flat-surfaced, circular sputtering target having an identifier 316 located at a preselected target depth. Identifier 316 can be in the form of a color, a texture, a specialized material composition, or can be a source for the release of a material. The only requirement is that a means be available for detecting the exposure of identifier 316 upon the erosion of sputtering target 300 from its initial sputtering surface 314 to the target preselected thickness at which identifier 316 is located. Identifier 316 can be positioned at particular sputtering target 300 circular coordinates relative to the surface area of heat transfer surface 312 or can be located across the entire surface area of sputtering target 300, as shown in FIG. 3A. Identifier 316 can extend all the way from the preselected target depth to heat transfer surface 312 if desired (not shown in FIG. 3A). FIG. 3B shows a sputtering target 330 having a porous gas-containing or gas-providing source 350 in communication with a pressurized source of gas 352 which also comprises a pressure sensitive switch 354.

The present invention pertains to a specialized sputtering target for use in glow discharge sputtering systems of the kind used in the semiconductor industry for the deposition of thin films on substrate surfaces. Typically such thin films are metallic, and the composition of the sputtering target is likewise metallic. The sputtering target can be of any desirable size or shape, depending on the sputtering apparatus and the substrate to which a sputtered film (or coating) is to be applied.

The sputtering target is constructed to have an identifier present at a preselected target depth. This sputtering target is used in combination with a means for detecting exposure of the identifier, which occurs when the target has been eroded to the preselected target depth. Use of the sputtering target of the present invention in combination with the detection means enables the determination of when the preselected target depth (or residual target thickness) has been reached. The identifier can be one which can be detected using optical, pressure variation, or material composition measuring means.

The identifier can be a passageway within the sputtering target or can extend from the preselected target depth all the way to the heat transfer surface of the sputtering target.

When the means for detecting the identifier is an optical detector, the identifier is typically different in color or texture from the general material comprising the sputtering target.

When the means for detecting the identifier depends on pressure variation or material composition measurement, additional possibilities arise. In one of the preferred embodiments of the present invention, the specialized sputtering target of the present invention is constructed to have at least one passageway located therein, which passageway becomes exposed when a particular amount of sputtering target thickness erosion occurs. The passageway exposure then acts as an indicator that a preselected residual target thickness has been reached in the target area at which the passageway has become exposed.

A highly preferred specialized sputtering target of the present invention is constructed in a manner which provides a gas source when erosion to a particular sputtering target depth occurs. That is, the gas source is typically located at a preselected distance of sputtering erosion travel through the target thickness, from the initial sputtering surface toward the opposite, exterior surface of the target at which heat transfer typically occurs. The gas source is preferably located close to the heat transfer surface of the sputtering target. A typical sputtering target about 0.5 inches thick lasts about one to two weeks in a sputtering apparatus which is in operation 24 hours per day. Thus, the maximum approximate rate of sputtering target erosion is about 0.003 inches (0.08 mm) per hour, and the gas source location within the sputtering target can be calculated based on this approximate maximum erosion rate. One skilled in the art can, with minimal experimentation, obtain erosion rate data for a particular kind of target and for a particular sputtering apparatus, and then calculate the desired gas source location precisely. For example, if it is desired to have approximately a one hour warning time prior to erosion penetration of the sputtering target, the gas source location can be calculated on this basis. For the 0.003 inch per hour erosion rate, the gas source location can be 0.003 inch from the heat transfer surface of the sputtering target.

There are various possibilities for the gas source, as previously described. For example, the gas source can be a conduit in which gas is entrapped or a conduit through which gas is infused from an outside source. The gas source can be gas which is entrapped or infused through a porous material, which underlies the entire target sputtering surface area at the preselected target depth.

The most preferred gas source is a conduit in which gas is entrapped or through which gas is infused from an outside source. When the gas source is a conduit, the gas source location must provide adequate sputtering target material thickness between the conduit and the sputtering target heat transfer surface to ensure that the heat transfer surface of the sputtering target will not collapse into the interior of the conduit during handling and operation of the sputtering target. This wall thickness of the conduit must also provide for machining tolerances. Typically a conduit location which is 0.03 inch from the heat transfer surface of the sputtering target is adequate.

Once gas is emitted from the gas source, the emission can be detected using a detection means such as a gas composition analyzer or a pressure change indicator. Upon indication that the sputtering target has been eroded to the preselected depth, the sputtering apparatus operational system can be affected, via a control device, to provide a desired result. For example, the sputtering apparatus can be shut down as a safety measure.

With reference to FIG. 1, which shows a cross-sectional side view of a sputtering apparatus 100, the sputtering target 110 has two major surfaces. The majority of heat removal from sputtering target 110 initially occurs at a back surface 112, and the initial sputtering of material from sputtering target 110 occurs at initial sputtering surface 114. The sputtered material is deposited on the surface of semiconductor workpiece 116, which can be moved into and out of vacuum chamber 117 by carrier 118. Sputtering target 110 comprises a conduit 120 which is filled with entrapped gas supplied from pressurized chamber 122. Pressurized chamber 122 includes a pressure sensitive switch 124 which is activated when gas begins to flow from conduit 120 and the pressure in pressurized chamber 122 decreases. Sputtering apparatus 100 can be shut down and sputtering discontinued in response to the activation of pressure sensitive switch 124, using control means known in the art.

As sputtering of material from sputtering target 110 is carried out, erosion of initial sputtering surface 114 occurs until the sputtering surface reaches the interior of conduit 120, the gas within conduit 120 is released, and the release is detected. An alternative to the use of pressure sensitive switch 124 for detection of the gas release is the use of a pressure measuring means (not shown) within vacuum chamber 117. The detected increase in pressure in vacuum chamber 117, upon release of the gas from conduit 120, can be communicated to a control means (not shown) which acts in response to the pressure increase. The pressure measuring means can be placed within vacuum chamber 117 at any location which does not interfere with the sputtering operation; however, it is advantageous to locate the pressure measuring means as near to conduit 120 as permissible. The pressure measuring means can be selected from those commercially available which can operate over the anticipated pressure and temperature ranges experienced within vacuum chamber 117. The pressure measuring means must be sufficiently sensitive to detect the amount of pressure change anticipated upon release of gas from conduit 120. The amount of pressure change depends on the quantity of gas available from the gas source and the rate of release of this gas upon exposure of conduit 120. When the amount of gas released is limited to gas entrapped in conduit 120 and there is no gas supply from an atmospheric or pressurized source external to sputtering target 110, the pressure measuring means must be more sensitive. One skilled in the art can calculate the anticipated pressure change at the location of the pressure measuring means and determine which commercially available means is acceptable.

For purposes of illustration, examples of commonly-used sputtering targets are shown in FIGS. 2A - 2C. The sputtering targets to which the present invention can be applied are not intended to be limited to the sputtering targets shown in these figures.

FIG. 2A shows a cross-sectional side-view schematic of a "dish-shaped" sputtering target 200, having heat transfer surface 212 and initial sputtering surface 214. Sputtering target 200 comprises a closed gas conduit 220 which provides a source for the gas to be released when the erosion of the sputtering surface of sputtering target 110 exposes the interior of the otherwise closed conduit 220. Sputtering target 220 includes mounting lip 210 which is used to attach sputtering target 220 to a sputtering apparatus (not shown).

Typically the interior of conduit 220 contains entrapped, pressurized gas. When the means for detecting emission of the gas from conduit 220 is a pressure change detection means (or other means not dependent upon gas composition analysis), the pressurized gas can be one of the gases which is ionized within the sputtering apparatus vacuum chamber (not shown). Thus, no foreign gas harmful to the sputtering process need enter the sputtering apparatus vacuum chamber. It is also possible to leave conduit 220 open to the atmosphere and to measure a vacuum chamber pressure change when atmospheric gases enter the sputtering apparatus vacuum chamber. When the means for detecting emission of the gas from conduit 220 is a gas composition analyzer (typically present in the sputtering apparatus vacuum chamber), the emitted gas must be different from that present in the sputtering apparatus vacuum chamber.

FIG. 2B illustrates a cross-sectional side-view schematic of a flat the sputtering target 230 which is commonly circular from a top view. Sputtering target 230 comprises heat transfer surface 242, initial sputtering surface 244, and gas conduit 250. Sputtering target 230 includes mounting lip 240 which is used to mount sputtering target 230 to a sputtering apparatus (not shown). Upon operation of the sputtering apparatus, the sputtering target surface is eroded until the interior of conduit 250 is exposed, resulting in the emission of gas from conduit 250. FIG 2C is an enlargement showing the area of sputtering target 230 which includes gas conduit 250 in more detail. Typically, by means of example and not by limitation, the diameter of conduit 250 is approximately two times the thickness of the sputtering target material located between heat transfer surface 242 of sputtering target 230 and the upper exterior 252 of conduit 250.

FIGS. 3A and 3B illustrate two additional embodiments of the specialized target of the present invention. Although these embodiments are operable without knowledge of the pattern of maximum target erosion, such sputtering targets are more expensive to manufacture.

FIG. 3A is a cross-sectional side view of a flat sputtering target 300 which typically has a circular configuration from a top view. Sputtering target 300 includes mounting lip 310, heat transfer surface 312, initial sputtering surface 314, and identifier 316. As previously described, identifier 316 can be a material having a color or texture which differs from that of the general sputtering material comprising the sputtering target; identifier 316 can be a specialized material composition; or identifier 316 can be the source for release of a material. The only requirements for the identifier are that it not be present in the volume between identifier 316 and initial sputtering surface 314, and that a means be available for detecting the exposure of identifier 316 upon the erosion of sputtering target 300 from its initial sputtering surface 314 to the preselected target thickness at which identifier 316 is located.

In a more preferred embodiment, identifier 316 is a porous material containing a gas source. By way of example and not by limitation, the porous material can be a sintered metal of the same composition as the remainder of sputtering target 300, with a gas infused within the interstices of the sintered metal. The porous material can comprise any material which provides good heat transfer while simultaneously enabling infusion of a gas. Preferably the porous material comprises the same material as that of sputtering target 300, but in a more porous form.

FIG. 3B shows a cross-sectional side-view schematic of a flat sputtering target 330 which is typically circular from a top view. Sputtering target 330 comprises: mounting lip 340, for mounting sputtering target 330 on a sputtering apparatus (not shown); heat transfer surface 342; initial sputtering surface 344; and a porous layer of material 350 which provides a gas source. In this embodiment, a gas is infused into porous layer 350 from a pressurized gas source 352 which includes a pressure sensitive switch 354. During the sputtering operation, the sputtering surface of sputtering target 300 is eroded away until porous layer 350 is exposed, at which time gas is emitted into the sputtering apparatus vacuum chamber (not shown) located beneath sputtering target 330. Emission of gas from porous layer 350 into the sputtering apparatus vacuum chamber causes gas to flow from pressurized gas supply 352 into porous layer 350. This gas flow reduces the pressure in pressurized gas supply 352, activating pressure switch 354 which can be used to shut down the sputtering operation, using known-in-the-art control techniques.

Typically the apparatus and method of the present invention will be used as a protective device to prevent damage to a sputtering apparatus which would occur if a cooling liquid used to remove heat from a sputtering target were to enter the sputtering apparatus vacuum chamber. The present invention enables maximum utilization of the sputtering target and detects abnormalities in the system which may affect target erosion rate in an unexpected manner. One skilled in the art can envision additional uses for the present invention in terms of overall process control, as actions other than shutting down the sputtering operation can be triggered by the information that a sputtering target has become eroded to a preselected thickness.

The preferred embodiments of the present invention, as described above and shown in the Figures are not intended to limit the scope of the present invention, as demonstrated by the claims which follow, since one skilled in the art can, with minimal experimentation, extend the scope of the embodiments to match that of the claims.

## Claims

1. An apparatus for detecting when a sputtering target becomes eroded to a preselected depth, said apparatus comprising:
a) a sputtering target including at least one identifier which can be exposed by erosion of the sputtering target; and
b) a means for detecting said exposure of said identifier.

2. The apparatus of Claim 1, further including a control means which acts in response to said detection of said exposure of said identifier to control the sputtering of said sputtering target.

3. The apparatus of Claim 1, wherein said identifier comprises a passageway which can be exposed by erosion of said sputtering target, and wherein said detecting means is capable of detecting the exposure of said passageway.

4. The apparatus of Claim 2, wherein said identifier comprises a passageway which can be exposed by erosion of said sputtering target, and wherein said detecting means is capable of detecting the exposure of said passageway.

5. The apparatus of Claim 3, wherein a gas source is present in said passageway, whereby a gas is released upon the exposure of said passageway, and wherein said means for detecting said exposure is a means for detecting said gas release.

6. The apparatus of Claim 3, wherein said passageway is a conduit from which said gas is released upon exposure of at least a portion of the interior of said conduit due to the erosion of said sputtering target.

7. The apparatus of Claim 6, further comprising a pressurized source of gas which supplies said gas to said conduit.

8. The apparatus of Claim 7, wherein said means for detecting said release of gas is a pressure sensitive switch which senses the release of said gas from said pressurized source of gas.

9. The apparatus of Claim 6, wherein said gas is entrapped in said conduit within said sputtering apparatus and is not connected to a pressurized source for said gas external to said target.

10. The apparatus of Claim 6, wherein said conduit is open to the ambient atmosphere.

11. The apparatus of Claim 6, wherein said means for detecting said release of gas is a pressure sensitive means located within a sputtering apparatus vacuum chamber which is in communication with said sputtering surface of said sputtering target.

12. The apparatus of Claim 6, wherein said means for detecting said release of gas is a gas composition analysis means located within a sputtering apparatus vacuum chamber which is in communication with said sputtering surface of said sputtering target.

13. A sputtering target having at least one identifier present at a preselected depth and not at depths less than said preselected depth, which identifier can be exposed upon erosion of said sputtering target.

14. The sputtering target of Claim 13, wherein said identifier exhibits a color which is different from that of the general sputtering material comprising said target.

15. The sputtering target of Claim 13, wherein said identifier exhibits a texture which is different from that of the general sputtering material comprising said target.

16. The sputtering target of Claim 13, wherein said identifier comprises at least one passageway which is present at said preselected target depth.

17. The sputtering target of Claim 16, wherein a gas source can be provided within said passageway.

18. The sputtering target of Claim 17, wherein said passageway is a conduit from which said gas can be released.

19. The sputtering target of Claim 18, wherein said conduit is filled with entrapped gas.

20. The sputtering target of Claim 18, wherein said conduit is connected to a pressurized gas source.

21. The sputtering target of Claim 18, wherein said conduit is open to the atmosphere.

22. The sputtering target of Claim 18, wherein said passageway is a porous layer of material.

23. The sputtering target of Claim 22, wherein a gas source can be provided within said passageway.

24. The sputtering target of Claim 23, wherein said gas source is a gas entrapped within said porous layer of material.

25. The sputtering target of Claim 22, wherein said porous layer of material has essentially the same composition as the composition of the non-porous portion of said sputtering target.

26. The sputtering target of Claim 25, wherein a gas source is provided within said passageway.

27. The sputtering target of Claim 26, wherein said gas source is a gas entrapped within said porous layer of material and is not connected to a pressurized source for said gas external to said target.

28. In a sputter deposition process, a method of detecting when a sputtering target becomes eroded to a preselected depth, said method comprising:
a) providing a sputtering target comprising at least one identifier present at said preselected target depth;
b) utilizing said sputtering target in a manner which may expose said identifier; and
c) detecting the exposure of said identifier, should such exposure occur.

29. The method of Claim 28, wherein said identifier comprises a passageway.

30. The method of Claim 29, wherein said passageway contains a gas which will be released upon the exposure of said passageway.

31. The method of Claim 30, wherein said detecting of the exposure of said passageway is accomplished by detection of the release of said gas from said passageway.

32. The method of Claim 28, further including controlling at least one variable within said sputtering deposition process in response to the detection of the exposure of said passageway.

33. The method of Claim 32, wherein said controlling results in the discontinuance of said sputtering deposition process.

34. In a sputter deposition process, a method of sputtering a target, said method comprising:
a) providing a sputtering target comprising at least one identifier present at a location within said sputtering target; and
b) sputtering said target.
c) detecting whether said identifier has during said sputtering been exposed.

35. The method of Claim 34, wherein said target is sputtered at least to the extent that said identifier is exposed and detecting said exposure.

36. The method of Claim 35, further including controlling at least one variable within said sputter deposition process in response to said detection of said exposure of said identifier.

37. The method of Claim 36, wherein said controlling results in the discontinuance of said sputtering deposition process.
